# EUROPEAN PATENT APPLICATION

(11) **EP 2 461 655 A1**
(43) Date of publication of application: **06.06.2012**
(21) Application number: 10193841.3
(22) Date of filing: 06.12.2010
(51) Int. Cl.: H05K 1/09, H05K 3/12

(54) **Hybrid materials for printing conductive or semiconductive elements**

(71) Applicant: Nederlandse Organisatie voor Toegepast -Natuurwetenschappelijk Onderzoek TNO, 2628 VK Delft (NL)
(72) Inventor: Abbel, Robert J., 2628 VK Delft (NL); Meulendijks, Nicole, 2628 VK Delft (NL); Meinders, Erwin Rinaldo, 2628 VK Delft (NL); Boersma, Arjen, 2628 VK Delft (NL)
(74) Representative: Jansen, Cornelis Marinus

(57) **Abstract**

The invention relates to a method for preparing a conductive or semi-conductive element, comprising
- providing a dispersion of an anisotropic particulate hybrid material in a continuous phase, which hybrid material comprises (a) anisotropic particles, and (b) a conductive or semi-conductive material or a precursor for a conductive or semi-conductive material;
- applying the dispersion to a surface of a substrate; and
- forming the conductive or semi-conductive element from the dispersion applied to the surface.

Further the invention relates to materials useful for use in a method of the invention and an electronic device obtainable by a method according to the invention.

## Description

The invention relates to a method for preparing a conductive or semi-conductive element, to a particulate anisotropic material, to a dispersion comprising a particulate anisotropic material, to a conductive or semi-conductive element, and to an electronic device comprising a conductive or semi-conductive element.

Conductive patterns can be provided on a substrate, *e.g.* in the manufacture of electronic circuits, using a conductive ink or paste. Conductive inks and pastes based on metal nanoparticles are known in the art. In order to be printable, the metal particles have to be dispersed in a liquid phase and protected from agglomeration and precipitation. This is may be done by coating the particles with a protective polymer coating which after printing and removal of the liquid phase (by drying) prevents the metal particles from getting in electrically conductive contact. Thus this coating has to be removed. This may be accomplished by heating, *e.g.* at a temperature of 150 - 300 °C. This limits the use thereof to printing on substrates that can withstand such substrates. Flexible electronics on polymeric substrates, for example, are often incompatible with thermal sintering above 110 - 150°C. Furthermore, heating to sintering temperature costs energy. Accordingly, there is an increasing demand for conductive inks that do not need sintering or that are sinterable at a relatively low temperature. Depending on the polymer coating, sintering may also be accomplished by irradiation. However, this may also have an adverse effect on the substrate, in particular if the substrate comprises a polymeric material. *E.g.* mechanical strength or flexibility may be reduced.

Further, sintering may add to the complexity of the method to provide a conductive pattern. Furthermore, the process of imparting the pattern with sufficient conductivity may be a lengthy process.

Various patent applications have been published directed to resin-based curable electrically conductive pastes. For instance EP 425 677 A1 describes a paste comprising an electron-beam curable resin, a heat-curable resin and a conductive powder. The (extensive) heating and irradiation with an electron-beam needed for curing the paste makes the paste and methodology of this document disadvantageous for analogous reasons as given above.

US 2009/0294739 A1 relates to a conductive paste which may be used for manufacturing a printed circuit board. The paste comprises a carbon nanotube, a metal alloy and a binder. It is the inventors finding that the alloy particles and the nanotubes are susceptible to phase separation after the paste has been deposited to form a conductive (micro)structure. The phase separation may cause deterioration of the final conductive structure and adversely affect its performance.

US 6,812,065 relates to a method for forming an electric connection circuit using a thermosetting anisotropic conductive paste. The term "anisotropy" is used here to characterise the end product (a conductive structure) that conducts electric currents preferably in one direction. The paste typically comprises an epoxy resin as a major component, a curing agent and conductive microparticles. A drawback of the technology described in this patent is that it is apparent that the paste has a relatively low maximum concentration of conductive particles. Further organic resin has the drawback of having the tendency to reduce the conductivity of the structure prepared by the paste (see *e.g.* US 2010/0009153, [0031]). Thus, it is contemplated that the structures obtained by a method according to this patent generally have a relatively low final conductivity. Furthermore, a (high) pressure needs to be applied for making a conductive structure.

US 2010/0009153 relates to an ink or paste that comprises a silver nanoparticulate material, a conductive microparticulate material and less than about 3 wt. % of a curable organic or polymeric resin. In practice, it is apparent that for good results, the sintering temperature is relatively high and/or the sintering time is relatively long. See for instance the Examples, where a sintering temperature of 150 °C and a sintering time of 5 min are used. Using two different mathematical models (a logarithmic one and a hyperbolic one), one can extrapolate a sintering time in the order of 15 to 25 seconds at 150 °C. It should, however, be noted that such high temperatures can cause problems during processing when polyester foils (such as in US 2010/0009153) are used.

It is an object to provide a novel method of manufacturing a conductive element, in particular on a heat- and/or radiation sensitive substrate, more in particular a substrate comprising an organic photoactive material, which method is suitable as an alternative to known methods. It is a further object to provide a novel conductive element, which may be obtainable by a method of the invention. It is yet a further object, to provide a material or composition which may be used in a method according to the invention.

In is in particular an object to address a drawback of the products or methods described in the above cited prior arts.

One or more further objects to which the invention relates will be apparent from the description herein below.

It has now been found that by using a specific composition one or more of the above objects are met.

Accordingly, the invention relates to a method for preparing a conductive or semi-conductive element, comprising
- providing a dispersion of an anisotropic particulate hybrid material in a continuous phase, which hybrid material comprises (a) anisotropic particles, and (b) a conductive or semi-conductive material or a precursor for a conductive or semi-conductive material;
- applying the dispersion to a surface of a substrate; and
- forming the conductive or semi-conductive element from the dispersion applied to the surface.

Further, the invention relates to a particulate anisotropic hybrid material which hybrid material comprises (a) anisotropic particles, and (b) a conductive or semi-conductive material or a precursor for a conductive or semi-conductive material, wherein the anisotropic particulate hybrid material is as defined in any of the preceding claims, the ratio anisotropic particles (a): to the conductive or semi-conductive material or a precursor for a conductive or semi-conductive material (b)

Further, the invention relates to a dispersion, which dispersion may be a fluid, in particular an ink or a paste, comprising a particulate hybrid material according to the invention.

Further, the invention relates to a (semi-)conductive element comprising a conductive or semi-conductive hybrid material according to the invention

Further, the invention relates to an electronic device comprising an element according to the invention.

The term "or" as used herein is defined as "and/or" unless specified otherwise.

The term "a" or "an" as used herein is defined as "at least one" unless specified otherwise.

When referring to a noun (*e.g.* a compound, an additive, etc.) in the singular, the plural is meant to be included.

The term 'conductive' is used herein for materials having an average specific electrical conductivity of at least about 5 Ω⁻¹cm⁻¹. In particular the term is used for materials having a electrical conductivity in the range of 0.1 to 100 % of common metals, *i.e.* in the range of 6.95 Ω⁻¹cm⁻¹ (0.1 % of bulk Mn) to 0.63-10⁶ Ω⁻¹cm⁻¹ (100 % of bulk Ag). This in particular applies to the element obtainable after deposition on a substrate and an optional curing step.

The term 'semi-conductive' is used herein for materials exhibiting an electronic band gap narrow enough to allow thermal promotion of electrons from the valence to the conductance band at such a rate that at ambient temperature specific electrical conductivities in the range of 10⁻⁸ to 100 Ω⁻¹cm⁻¹ result. In particular, the upper limit for the semi-conductive material is equal to the lower limit for the conductive material, as indicated above.

It has been found that a conductive or semi-conductive (herein after also referred to as '(semi-) conductive) element can be made relatively fast and/or under relatively mild conditions from a dispersion comprising the anisotropic hybrid material compared to a method wherein a comparable dispersion is used wherein a (semi)-conductive material or precursor thereof is dispersed as such. See for instance, the examples, which show an about 5-fold decrease in the time needed to form a conductive element having a target conductivity. This makes a method according to the invention particularly suitable for use in a continuous production process, *e.g.* of an electronic device, in particular an organic electronic devices.

Further, it has been found that a (semi-)conductive pattern obtained with an ink according to the invention has a considerably higher conductivity than an ink of comparible composition (also comprising anisotropic particles, but in a non-hybrid mixture).

It is surprising that the presence of a material with a relatively low conductivity, in particular a non-conductive material (clay), in the hybrid does not have the opposite effect. One would expect that a higher content of non-conductive ingredients in the dispersion would result in a longer time needed to achieve a target conductivity.

The relatively fast rate at which the (semi-)conductive element can be formed in accordance with the invention is particularly advantageous in that the exposure of a substrate to potentially damaging heat or irradiation can be reduced or even avoided.

Additionally, an increase in curing speeds can make roll-to-roll productions processes faster and thus increasing production capacity.

Further, it is contemplated that the present invention allows advantageous manufacture of a conductive element comprising a highly reactive (*e.g.* oxidisable) conductor or semi-conductor (compared to noble metals such as silver or gold), for instance aluminium.

It is further contemplated that the dispersion for forming the (semi-) conductive element (which may be an ink or a paste) has a relatively high chemical stability, *e.g.* against oxidation if the (semi-)conductive material or precursor is oxidisable, *e.g.* if the conductive material comprises a non-noble metal, for instance aluminium, also in the absence of agents that support the maintenance of the metal in a zerovalent state. Thus, it is contemplated that a dispersion according to the invention may be processed and stored without needing a protective atmosphere (a gas that is not reactive with the (semi-)conductive material or precursor).

The term 'hybrid' as used herein in particular is used as a noun or adjective to describe a material or product (such as in 'hybrid material', 'hybrid particles' etc) in which the anisotropic particles and the (semi)conductor material or precursor thereof (usually nanoparticles) are bound to each other, more in particular bound by specific interactions as described below. The anisotropic particles are primarily present for providing the anisotropic shape of the hybrid of the anisotropic particles and the (semi)conductive nanoparticles. Therefore, the anisotropic particles without the (semi)conductor material or precursor thereof may also be referred to as 'the template'.

The anisotropic particulate hybrid material comprises anisotropic particles and the (precursor for) the (semi-)conductor material, bound together (in a formulation prior to deposition on a substrate) usually by a chemical force which may be essentially covalent or essentially non-covalent. Non-covalent forces are in particular, non-covalent interactions: hydrogen bonds, ionic bonds, coordination bonds, van der Waals forces, dipole-dipole bonds, and hydrophobic interactions. Preferably the template and (precursor for) (semi-) conductive material are bound by a relatively strong force, in particular an ionic bond or a coordination bond. These types of bonds are generally known in the art.

The term 'coordination bond' is defined herein in particular as "a chemical connection between metallic atoms or ions and organic or inorganic moieties (so-called ligands), that is formed by electron pair donation from the ligands into empty orbitals of the metallic component. In some cases, the connection can additionally be stabilised by electron back-donation from the metal to the ligands."

The term 'ionic bond' is defined herein in particular as a chemical connection between atomic or molecular entities of opposite electrical charge, the binding energy of which is at least partially, preferably predominantly or fully (more than 50 % to 100 %) attributed to electrostatic attraction rather than sharing electrons in common molecular orbitals."

In particular, good results have been achieved with a hybrid material wherein template and (precursor for) (semi-)conductive material are bound by ionic bonds and by coordination bonds, In particular, in case a coupling agent is used to couple the template and the (semi)conductive material or precursor thereof, the coupling agent may form an ionic bond with one of the two and a coordination bond with the other. Usually the template (which should comprise ionic groups) will then bind to the coupling agent via an ionic bond.

For instance, binding between (semi)conductive nanoparticles, such as silver nanoparticles, and (exfoliated) anionic clay (as a template) with an ammonium mercaptane (coupling agent) is achieved by two or more types of interactions: ionic bonds between the ammonium functionality of the coupling agent and the negatively charged clay mineral, and a coordination bond between the mercaptane group of the coupling agent and the silver particle.

Similarly, replacing the cationic functionality for an anionic functionality (e. g. a carboxylate), a hybrid with a cationic clay may be provided.

The anisotropic particulate hybrid material advantageously has a core-shell morphology. The particles with a core-shell morphology have a core of an anisotropic particle (a) which is at least substantially surrounded by a layer of the (precursor for) the (semi-)conductive material. As used here, 'at least substantially' means sufficient to provide conductivity in an element formed from the hybrid. In general, more than 50 % of the surface is covered, in particular more than 80 %, more in particular 90-100 % of the surface, as can be determined by scanning electron microscopy.

The anisotropic particulate hybrid material can be prepared from anisotropic particles and a (semi-)conductive material or a precursor for a (semi-)conductive material known *per se*. The material of which the anisotropic particles are made does not need to be conductive. It may be an electrically insulating material, a semi-conductor material or a conductor-material.

The anisotropic particles may in particular have an (average) aspect ratio of at least 1:5, preferably of 1:10 to 1:10000, in particular of 1:100 to 1:1000 as determined by laser diffraction (Deriemaeker, R. Finsy: Part. Part. Syst. Charact. 2005, 22, 5 - 13).

The particle size of the anisotropic particles usually is in the range of 1 nm to 100 nm (shortest dimension) and 100 nm to 100 µm (longest dimension), in particular in the range of 1 nm to 10 nm (shortest dimension) and 100 nm to 10 µm (longest dimension), as determined by the same techniques as mentioned above. The anisotropic particles may for instance have a sheet-shape, a platelet-shape, a rod-shape, a tubular shape or a needle-shape.

The anisotropic particles (a) may in particular be selected from the group of graphite anisotropic particles (such as graphite sheets), carbon-nanotubes, clay minerals, inorganic layered chalcogenides (MoS₂ or WS₂) or oxides with the tendency to form nanosheets and nanorods (ZnO, TiO2). In particular good results have been received with an exfoliated clay. In a specifically preferred embodiment, the anisotropic particles are clay platelets.

The clay can be a natural clay or a synthetic clay.

In a preferred embodiment, the anisotropic particles comprise a clay selected from the group of phyllosilicates with high cation exchange capacity, such as laponite, bentonites, montmorillonites or vermiculites. In particular good results have been achieved with an anionic phyllosilicate, notably (Na_{0.7}[(Si₈Mg_{5.5}Li_{0.3})O₂₀(OH)₄] (Laponite). Further, good results have been achieved with a magnesium silicate, in particular Sepiolite.

In a preferred embodiment, the conductive or semi-conductive material is selected from metals, *e.g.* transitional metals of groups 8-12 and semi-metals. In particular, the metal may be selected from the group of aluminium, gallium, silver, gold, copper, nickel. As a semi-metal silicon is of particular interest. Non-elemental semiconductive materials in particular include gallium indium zinc oxide (GIZO), copper indium gallium selenide (CIGS), gallium nitride (GaN), gallium arsenide (GaAs), indium phosphide (InP) and cadmium indium selenide (CIS), cadmium selenide (CdSe), cadmium sulphide (CdS), zinc sulphide (ZnS), and silicon carbide (SiC).

In a specific embodiment, the hybrid comprises a precursor for any of said conductive or semi-conductive materials. Precursors are in particular ions/salts of the mentioned elements may be based on those known in the art, *e.g.* as described in any of the following publications: General: B. L. Cushing, V. L. Koleshnichenko, C. J. Oçonnor: Chem. Rev. 2004, 104, 3893. Metal and Semiconductor nanoparticles: C. B. Murray, C. R. Kagan, M. G. Bawendi: Ann. Rev. Mater. Sci. 2000, 30, 545. Noble metal nanoparticles: T. K. Sau, A. L. Rogach: Adv. Mater. 2010, 22, 1781. Cu and Fe nanoparticles: M. Valle-Orta et al.: J. Phys. Chem. B 2008, 112, 14427. Metal oxide nanoparticles: M. Niederberger, G. Garnweitner: Chem. Eur. J. 2006, 12, 7282. T. Trindade, P. O'Brien, N. L. Pickett: Chem. Mater. 2001, 13, 3843.

The conductive or semi-conductive material or precursor for such material usually is provided in a microparticulate or nanoparticulate form, preferably in a nanoparticulate form. The number average particular size, as determined by electron microscopy (SEM or TEM), or X-ray scattering (SAXS and WAXS) J. T. Lue: J. Phys. Chem. Sol. 2001, 62, 1599 usually is in the range or 1 to 500 nm, preferably in the range of 5 to 200 nm, in particular in the range of 10 to 100 nm. It should be noted though, that in the final hybrid material these particles usually have joined to form a larger structure, such as a layer on the anisotropic particulate material (a).

The anisotropic particles (a) and the conductive or semi-conductive material or precursor for the conductive or semi-conductive material (b) are usually provided in a wt. to wt. ratio (a):(b) in the range of 100 : 1 to 1 : 20000, preferably of 1 : 1 to 1 : 5000, in particular of 1 : 10 to 1 : 2000. In particular in an embodiment wherein the template (s) is an anionic phyllosilicate, such as laponite, or the like and the conductive material (b) comprises silver nanoparticles the ratio (a):(b) advantageously is chosen in the range of 1 : 100 to 1 : 1000. In case the conductivity of the anisotropic particles is lower than the conductivity of the (semi-)conductive material, a relatively low ratio (a):(b) is preferred for a relatively high conductivity. A relatively high ratio (a):(b) is preferred for a relatively high sintering rate at a given temperature, or for a low minimally needed sintering temperature at a given sintering time.

The preparation of the anisotropic particulate hybrid material typically comprises contacting of the anisotropic particles and the (precursor for) the (semi-conductor) material under conditions wherein they are bound together.

In order to accomplish or improve the bonding the anisotropic particles or the (precursor for) the (semi-conductor) material may be pretreated. Such pretreatment may in principle be based on known technology, depending on the anisotropic particles or/and (precursor for) the (semi-conductor) material used. For instance, if the surface of the anisotropic particles is considered too inert for bonding with the (precursor for) the (semi-conductor) material, it may be functionalised. For instance, its surface may be provided with functional chemical groups, *e.g.* the surface may be provided with a coupling agent. The coupling agent usually has a functional group that can attach to the surface of the anisotropic particulate material, *e.g.* a reactive group that can react with a reactive group of said surface or a net charge opposite to the net charge of said surface. Couples of reactive groups may be based on those known in the art, *e.g.* one may be a carboxylic acid and the other an amine, one may be a hydroxyl or thiol and the other a carboxylic acid. Other possibilities include the click reaction of acetylenes with azides (also generally known as the Azide alkyne Huisgen cycloaddition) the reaction of amines or alcohols with isocyanates, or the addition of nucleophiles to (highly strained) epoxides or aziridines or the reactions of silanes to -OH moieties on the surface.

In particular, if the surface of a material is provided with a net-charge, a coupling agent may be used that has an opposite net-charge. *e.g.* mercapto-alkane-ammonium may be bound to the surface with a negative charge via the ammonium, leaving the mercapto group for coupling the other material.

The coupling agent further has a functional group with affinity for the (semi-)conductor or precursor therefore. The coupling agents may be selected from coupling agents that are known to be suitable for coupling of a specific precursor for the (semi-conductor) material to a surface. For instance, mercaptanes (*e.g.* mercaptopropane) may serve as a coupling agent for silver or gold. Compounds with a functional group that has a suitable affinity towards metals and their precursors may in particular be selected from: organic sulphur compounds (thiols, thioethers, thioesters, disulphides), phosphines, aliphatic amines, pyridines and carboxylates. Especially interesting are chelating ligands which have more than one binding site. Functional groups that have a high affinity towards semiconductors: phosphine oxides, phosphonic acids and amines. A compilation of ligands of various types can be found in: J. A. McCleverty, T. J. Meyer (eds.): Comprehensive Coordination Chemistry II, 2003, Elsevier.

In particular if the surface of the anisotropic material does not comprise suitable functional groups or to few suitable functional groups, the surface may be pre-treated to form such groups. *E.g.* materials may be oxidised, as described in D. R. Dreyer et al.: Chem. Soc. Rev. 2010, 39, 228, before contacting the material with the other component. Oxidation is in particular advantageous for carbon-materials. Further, an ion-exchange treatment may be used to impart functional groups, or a plasma treatment (usually of the particles dispersed in a gas phase).

In an advantageous embodiment, the anisotropic particles are clay particles, which are subjected to an exfoliation treatment. Such treatments are generally known for various clays. After exfoliation the coupling agent is added. In particular in case of an anionic clay, the coupling agent may suitably be added as a cation.

The clay or other anisotropic particles, comprising functional groups to which the (precursor for) the (semi-)conductive material can bind, are then contacted with the (precursor for) the (semi-)conductive material under conditions wherein the binding takes place. Suitable conditions depend on the specific materials and functional groups, but can readily be established based on common general knowledge, the information disclosed herein an optionally some routine testing.

Advantageously, the anisotropic particles are at least substantially covered with a layer of the (precursor for) the (semi-)conductive material. Advantageously, the anisotropic particles are at least substantially covered with a layer of the (precursor for) the (semi-)conductive material.

In order to prepare the hybrid, the anisotropic material is usually dispersed in a dispersion medium (which may be liquid or gas), *e.g.* water, a hydrocarbon, or, a noble gas or nitrogen.

For obtaining a fine dispersion, it may be preferred to subject the anisotropic material in the dispersion medium to a treatment selected from the group of (ultra) sonication, (high-speed) stirring, shaking, heating, irradiation with a laser, addition of dispersing agents. Such treatment may also be advantageous to improve an exfoliation process (in case clay is used for providing the anisotropic particulate material).

The (semi-)conductor or precursor therefore is usually added after the dispersion of the anisotropic particulate material has been made. This step may comprise simply mixing the (semi-)conductor or precursor into the dispersion. The preparation may be carried out under ambient conditions, or the dispersion may be heated during mixing. The mixture may be subjected to (ultra)sonication. If desired, an ion-exchange step may be carried out. An ion-exchange step may in particular be used to exchange alkali or earth alkali cations, which may be present in the particulate material, in particular if it is a material with negatively chargeable groups for example a silicate based clay or other silicate, to counterbalance the negative charges in the. By chemical treatment, these ions can be replaced by other (metal) ions. Suitable ion exchange process are known in the art, for instance in "Cation exchange and adsorption on clays and clay minerals" (dissertation by L. Ammann, University of Kiel, 2003, available via the internet: http://deposit.ddb.de/cgi-bin/dokserv?idn=971657661&dok_var=d1&dok_ext=pdf&filename=971657661. pdf).

If desired, the anisotropic particles can be provided with reactive groups, in particular with polymerisable groups, such as (isolated or conjugated) double bonds, epoxide funcionalities and the like. Examples thereof are described in Polymer 2008, 49, 2636 and Polymer 2007, 48, 1490.

Upon polymerisation of polymerisable groups the anisotropic particles, such as clay platelets, are bound together chemically. The bound is usually essentially irreversible (at least under normal conditions of use), thereby fixating the parallel arrangement. The binding of the anisotropic particles by polymerising the polymerisable group in particular contributes to a beneficial sintering behaviour of the metal nanoparticles in these materials, when used to prepare a conductive or semi-conductive element.

In order to avoid negative interference between the polymerisable groups and the (semi)conductive elements, the clays can be functionalised selectively at the edges and facets to make sure both functionalities are attached only at specific locations on the platelets. This selective functionalisation can be achieved by making use of the differences in surface chemistry on the different locations. Examples for location-selective functionalisation of clay minerals can be found in J. Appl. Pol. Sci. 2007, 106, 1496 and Pol. Comp. 2009, 30, 1234.

The mixing is generally carried out under conditions wherein the (semi-)conductor or precursor therefore will be attached to the surface of the anisotropic particulate material. After formation of the hybrid, the hybrid may be recovered from the dispersion in a manner known *per se* for separating small particles from a dispersion, *e.g.* by filtration or by centrifugation. Whether this is desired depends on whether the dispersing medium used is suitable for use in the dispersion that is used for forming the (semi-)conductive element.

The preparation of the dispersion for forming the (semi-)conductive element may be prepared based on methodology known *per se*, *e.g.* on S. Magdassi (ed.): The chemistry of inkjet inks (World Scientific, 2009, ISBN 978-981-281-821-8). R. Leach, R. Pierce (eds.): The Printing Ink Manual (Kluwer Academic Publications, 1993, ISBN 978-0-948905-81-0). The preparation may comprise ball-milling or (ultra) sonication. Depending on the intended purpose, in particular depending on the intended application method, properties such as solid-content, surface tension, viscosity etc. can be adjusted by appropriate dispersion medium (continuous phase) and concentration choice, the addition of further additives. This may based on methodology known *per se*, *e.g.* on methodology described in the prior art cited herein.

Generally, a relatively high concentration for the hybrid material in the dispersion is preferred in view of a fast formation (low curing/sintering time) of the conductive or semi-conductive element.

Usually a maximum for the concentration of the hybrid material in the dispersion (such as the ink) is in particular determined by the maximum concentration that still allows satisfactory applying the dispersion in a method according to the invention.

A desired maximum, in particular depends on the application technique, as will be understood by the skilled person. Factors that are in particular taken into account for an advantageous hybrid material concentration in the dispersion are viscosity and surface tension. Further a factor like adhesion to the substrate and the like may in particular be taken into account, as will be appreciated by the skilled person.

Usually, the concentration is at least 10 wt. %, in particular at least 15 wt. %, at least 20 wt. %, at least 25 wt. % or at least 40 wt. %. Usually the concentration of the hybrid material is 90 wt. % or less, in particular 80 wt. % or less, 70 wt. % or less, 60 wt. % or less or 40 wt. % or less.

Typical concentrations of hybrid material in an ink for inkjet printing are in the range of 10 - 40 wt%, for flexo, gravure, screen print and offset inks in the range of 50 - 90 wt%.

Preferred viscosity values for inkjet printing are in the range of 1 - 30 mPas at the temperature at which the ink is printed, which is usually well below the boiling point of the most volatile solvent, preferably at room temperature (25 °C), for gravure printing 10 - 200 mPas, for flexo printing 20 - 500 mPas, for screen printing 0.5 - 50 Pas and for offset printing 2 - 100 Pas. Typical methods to determine the viscosity of an ink are capillary viscometry for inks with relatively low viscosities (below 50 mPas) (X. Wang et al.: Rev. Sci. Instr. 2010, 81, 065106) or torsion flow rheometry for inks with higher viscosities (D. C. Vadillo et al.: J. Rheol. 2010, 54, 781). The surface tension is especially important for inkjet inks and should have values between 20 and 40 mN/m at room temperature (25 °C). It can be quantified by contact angle measurements (D. Y. Kwok, A. W. Neumann: Adv. Coll. Interf. Sci. 1999, 81, 167).

Suitable dispersion media in which the hybrid is dispersed may in particular be selected from the group of water, liquid aliphatic hydrocarbons and aromatic hydrocarbons, liquid alcohols, liquid ketones, liquid ethers, liquid esters. When referred herein to 'liquid' it means liquid at application temperature, in particular liquid at 25 °C.

More in particular a suitable dispersion medium may be selected from the group of linear alkanes, branched alkanes and cyclic alkanes with 8 to 15 carbon, such as n-octane, n-nonane, n-decane, n-dodecane, isomers of methylheptane, methyloctane, methylnonane, dimethylhexane, dimethylheptane, demethyloctane, ethylhexane, ethylheptane, ethyloctane and the like, cyclooctane, cyclononane, cyclodecane, etc., decaline, toluene, xylene isomers, trimethylbenzene isomers, tetramethylbenzene isomers, ethylbenzene, propylbenzene, isopropylbenzene (cumene), indane, tetraline, methanol, ethanol, propanol, isopropanol, n-butanol, sec-butanol, tert-butanol, isobutanol, n-pentanol and its branched isomers, cyclopentanol, n-hexanol and its branched isomers, cyclohexanol, n-heptanol and its branched isomers, n-octanol and its branched isomers, benzyl alcohol, tetrahydrofurfuryl alcohol, ethylene glycol, propylene glycol, 1,3-propanediol, 1,4-butanediol, alpha-terpineol, methoxyethanol, diethylene glycol, triethylene glycol, acetone, butanone, 2-pentanone, 3-pentanone, cyclopentanone, 2-, 3-, 4-hexanol, methylisobutyl ketone, cyclohexanone, diisobutylketone, acetophenone, tetrahydrofurane, 1,4-dioxane, diisopropylether, dimethoxyethane, diglyme, triglyme, diphenylether, tert-butyl-methylether, anisole, veratrole, methyl acetate and other alkyl acetates, methyl propionate and other alkyl propionates, methyl butyrates and other alkyl butyrates etc.

The weight to weight ratio of the hybrid material to the dispersion medium usually is in the range of 5 : 95 to 99 : 1, in particular in the range of 10 : 90 to 95 : 5.

In addition, the dispersion for forming the (semi-conductive) element may comprise one or more additives selected from the group of viscosity-modifiers, dispersing agents and surface tension modifiers. Such agents are commonly known in the art *per se*. A specific substance may have more than one function, *e.g.* be both a viscosity modifier and a dispersing agent. Suitable viscosity modifiers are polymers that are soluble or dispersible in the dispersion medium. Examples of viscosity modifying polymers which may *e.g.* be used in an aqueous dispersion medium are starch, cellulose derivatives, poly(ethylene glycol), poly(vinyl acetate), or poly(vinyl alcohol).

Example of dispersing agents are poly(vinyl pyrolidone) and poly(vinyl alcohol).

Examples of surface tension modifiers are tensides and surfactants. The tension modifier can be anionic (e. g. sodium dodecylsulphate), cationic (e. g. triethylbenzylammonium bromide), or neutral (e. g. poly(ethylene oxide)-co-poly(propylene oxide)). These may be added in a conventional amount, *e.g.*. as described in.S. Magdassi (ed.): The chemistry of inkjet inks (World Scientific, 2009, ISBN 978-981-281-821-8). R. Leach, R. Pierce (eds.): The Printing Ink Manual (Kluwer Academic Publications, 1993, ISBN 978-0-948905-81-0).

The dispersion may be applied to a variety of substrates. The surface of the substrate may be a plastic, a glass, a ceramic, a metal, or a hybrid material comprising two or more of said materials. The surface can be flat or three-dimensionally shaped.

In an advantageous embodiment, the dispersion is essentially free of curable resins or other organic compounds that may form a crosslinked polymer network (*e.g.* multifunctional monomers or oligomers), *e.g.* by exposure to (electromagnetic) radiation or heat (under the conditions that apply for forming the element of the invention). If present, such compound or compounds is usually present in a relatively low concentration, in particular a concentration of less than 3 wt. % based on the weight of the dispersion, in particular less than 1 wt. % based on the weight of the dispersion. The absence of such compound or a low concentration thereof has been found advantageous with respect to a high conductivity of the formed element.

The dispersion may be applied to a surface of a substrate in a manner known *per se*. Preferably, the dispersion is applied to the surface using a printing technique, in particular using a printing technique selected from inkjet printing, flexo printing, screen printing, gravure printing, valve printing and aerosol jetting.

The dispersion may be applied to the substrate in a continuous process, in particular by roll-to-roll processing, or in a batch process. Due to the possibility to form a (semi-)conductive element relatively fast, the present invention in particular offers an advantages in continuous process, as in such process the forming of the (semi-)conductive element may be the time-limiting step in conventional techniques.

Once the dispersion is applied to the surface of the substrate, the applied material (defining the element that is formed) is usually subjected to a treatment whereby the dispersion medium is removed, usually by evaporation of the medium. At least on some embodiments, removal of the dispersion medium results in an element with sufficient conductivity. In order to increase the conductivity or improve a mechanical property of the element such as cohesion or adhesion to the substrate, the applied material may be subjected to a sintering step. The sintering may be based on a known technique. Suitable sintering techniques include a heating treatment; irradiation, preferably with electromagnetic radiation, *e.g.* ultraviolet, visible, infrared, microwaves or radiowaves; electrical curing; plasma sintering. Also if such a technique is used, the invention is considered advantageous in that a less intensive sintering or a shorter sintering may suffice in order to result in an element with a desired target conductivity.

For instance, thermal sintering may be accomplished at a considerably lower temperature or within a shorter time-span than with a comparable conventional technique. For instance, good results have been reached with a thermal sintering step at a temperature of not exceeding 130 °C, in particular at a temperature of 110 °C or less, more in particular at a temperature in the range of 70-110 °C. Thus, the invention also allows a sintering in case substrates comprising a heat-sensitive material are used, as is common for organic electronic devices. Thus, in an advantageous embodiment, the method of forming the conductive or semi-conductive element is carried out at a temperature below 100 °C, in particular at a temperature between ambient temperature (*e.g.* 20 °C) and 80 °C. Thermal sintering at a relatively low temperature may be accomplished in accordance with the invention without needing to formulate a dispersion for forming a (semi-) conductive elements (in particular an ink) wherein a (semi)conductive material or precursor therefore is dispersed as ultrafine nanoparticles in the dispersion medium. Such inks generally require the nanoparticles to be carefully stabilised, due to their highly reactive nature (large surface to volume area), especially if the nanoparticles are of a readily oxidisable material, *e.g.* aluminium. Also, such nanoparticles may be difficult to disperse well in the dispersing medium, and may therefore limit the choice of materials and/or the maximum concentration in which they may be dispersed.

The method of preparing a (semi-)conductive element may in particular be part of a method for manufacturing an electronic device, more in particular organic electronic device. Organic electronic devices are electronic devices wherein an organic electro-active material is present, as is in agreement with common use of this term in the art. Organic electronic devices usually contain an electro-active organic layer (*e.g.* an electro-active polymeric material) and at least two electrode layers, which do not need to comprise organic material. Such devices are generally known and have *e.g.* been described in WO 2005/015173, WO 2005/001945 and in WO 2008/12711, of which the contents are incorporated herein by reference.

In a specific embodiment the electronic device is a light emitting diode, a photovoltaic cell or a solar cell. In another specific embodiment the electronic device is a part of a packaging, wherein the device performs a function (such packaging is also referred to as 'smart packaging'), *e.g.* wherein the device comprises a sensor that monitors a relevant aspect of the packaging or its content. Such device may for instance be intended for monitoring the freshness of food in a packaging. Another example of a smart packaging is a packaging for a medicament or the like wherein the device detects when a medicament has been taken, or whether the medicament has been taken at a correct time. A packaging comprising an electronic device and wherein the smart packaging. Smart packaging is a type of packaging that adds functionality more than only shielding the contents from detrimental influences from the environment, such as light, oxygen, water, or bacteria. E. g., the extra functionality may be a sensor that monitors the quality of food, or that indicates whether the contents has been warmed up during transport above an allowed temperature maximum. Another application is a medicine packaging that registers whether a pill has been taken at the correct time by measuring when the packaging was broken. In a further embodiment the electronic device is a radio-frequency identification (RFID) device. Any of such devices according to the invention may have a design which is known *per se*.

The invention will now be illustrated by the following examples.

### Example 1

Two beakers containing 5 grams Sepiolite (Pangel S9, supplied by Tolsa SAeach), having a cation exchange capacity = 16 meg/100g, were filled with 1 litre water to swell the clay and stirred during 6 hours. The pH was decreased to 4 and 0.14 g of 2-(diethylamino) ethanethiol.HCl was added to the first (E1.1) and 0.09 g of 2-aminoethanethiol.HCl was added to the second (E1.2). The mixtures were stirred for 48 hours and washed 3 times with 0.01 M of HCl. 2g of mixture E1.2 was mixed with a colloidal dispersion of 15 nm gold particles. The reddish gold dispersion turned colourless and the clay became reddish, indicating that the gold particles were bound to the clay.

### Example 2

Two beakers containing 5 grams Laponite RD (Rockwood additives) each (cation exchange capacity = 74 meg/100g) were filled with 1 litre water to swell the clay and stirred during 6 hours. The pH was decreased to 4 and 0.61 g of 2-(diethylamino) ethanethiol.HCl was added to the first (E2.1) and 0.41 g of 2-aminoethanethiol.HCl was added to the second (E2.2). The mixtures were stirred for 48 hours and washed 3 times with 0.01 M of HCl. 2g of mixture E2.2 was mixed with a colloidal dispersion of 15 nm gold particles. The reddish gold dispersion turned colourless and the clay became reddish, indicating that the gold particles were bound to the clay.

### Example 3 (reference)

400 mg Laponite clay (E2.2) were dispersed in 0.6 ml of a 50:50 (v/v) mixture of ethylene glycol and ethanol. 0.3 ml Cabot ink were added and the mixture dispersed by ultrasonication for 15 minutes. The highly viscous mass that resulted was diluted with 0.4 ml of the same solvent mixture as above mentioned. Lines were deposited on PEN foil and glass by the same method as for the clay-nanoparticle hybrid materials. No conductivity was measured after 5 minutes of thermal sintering at 130 °C. After 40 more minutes at 130 °C, some (but not all) samples showed very low conductivities, corresponding to a electrical resistance in the order of several M Ω. No conductivity at all could be measured in the other samples.

### Example 4

To 2 ml of the dispersions E1.1, E1.2, E2.1 and E2.2 (0.04 g clay each) 0.05 g of a silver dispersion was added (20wt% silver). The thus obtained mixtures were washed with ethanol/ethylene glycol (1:1) three times.

### Example 5

To 2 ml of the dispersions E2.1 and E2.2 (0.04 g clay each) three copper in ethanol dispersion were added (E5.1:Plasmachem (13-40 nm), E5.2:Plasmachem (40 nm) and E5.3:Ioitec (50 nm)), to reach a ratio of 0.01 g CU to 0.04 g clay. The thus obtained mixtures were washed with ethanol three times and diluted with ethanol. It was found that the dispersion E5.1 was more stable than dispersion E5.3. In E5.1 no phase separation was observed between a clay and a copper phase as was the case for E5.3.

### Example 6

### Characterisation of unsintered samples

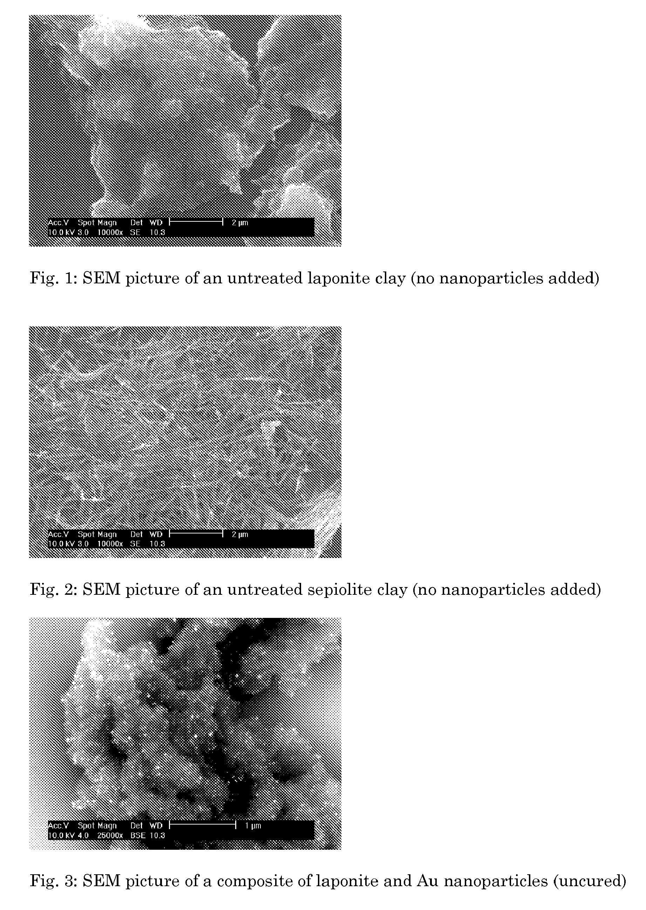

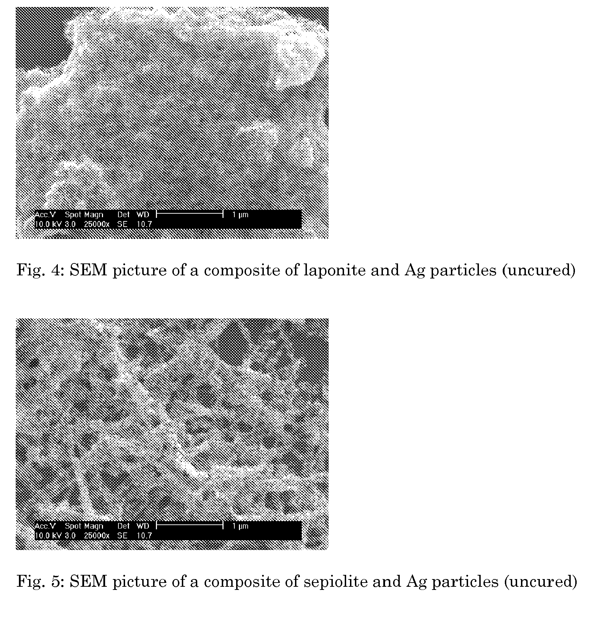

A small amount of the materials dispersion (typically a few mg) was diluted with isopropanol (ca. 1 ml), and a droplet was deposited on a silicon wafer. The solvent was evaporated under ambient conditions and the sample was coated with a conductive layer of carbon by physical vapour deposition. The samples were then investigated by SEM (scanning electron microscopy) using an SEM XL40 FEG. Both secondary (SE) and backscatter (BSE) photographs were taken. Photographs of several samples are shown in Figures 1-6

### Sintering

The sample setup consisted of a four-point probe of screen printed silver (DuPont Conductor Paste 5025) on poly(ethylene naphtalate) foil (thickness 125 µm, DuPont Teijin Films) that had been thermally annealed at 130 °C for at least 30 minutes in order to reduce its intrinsic resistivity to a minimum. A line of test dispersion was laid down on the printed silver structures by means of an Eppendorf pipet, and the resistance was measured over a distance of 25 mm using a Keithley 2100.

For thermal sintering, the sample was put into an oven set to a predetermined temperature and the line resistance is measured as a function of time.

For photonic sintering, the sample was put into the focus line of a flash sintering tool constructed according to WO 2010/036116 A1. The light source was a Philips XOP-25 Xe flash lamp (1000 W at maximum intensity) and the line resistance was measured as a function of time.

For SEM characterisation of sintered samples, a part of the sintered material was cut out, coated with carbon by physical vapour deposition and measured in an identical way as the unsintered samples.

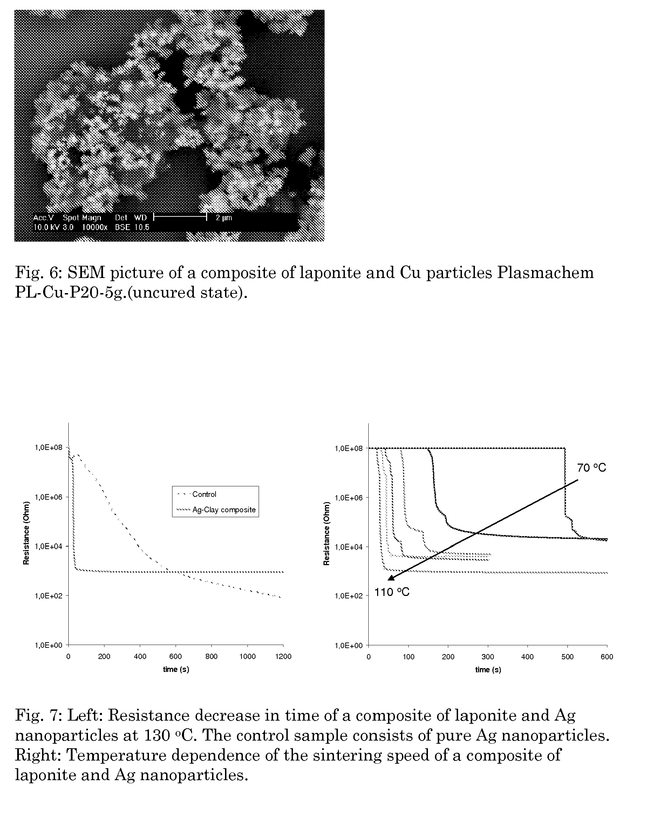

Figure 7, left shows the resistance decrease in time of a composite of laponite according to the invention compare to Ag nanoparticles (control) at 130 oC. The control sample consists of pure Ag nanoparticles.

Figure 7, right: shows the temperature dependence of the sintering speed of a composite of laponite and Ag nanoparticles according to the invention. It is shown that a stable conductivity is reached faster with increasing temperature from 70, to 75, 80, 90, 100 and 110 °C.

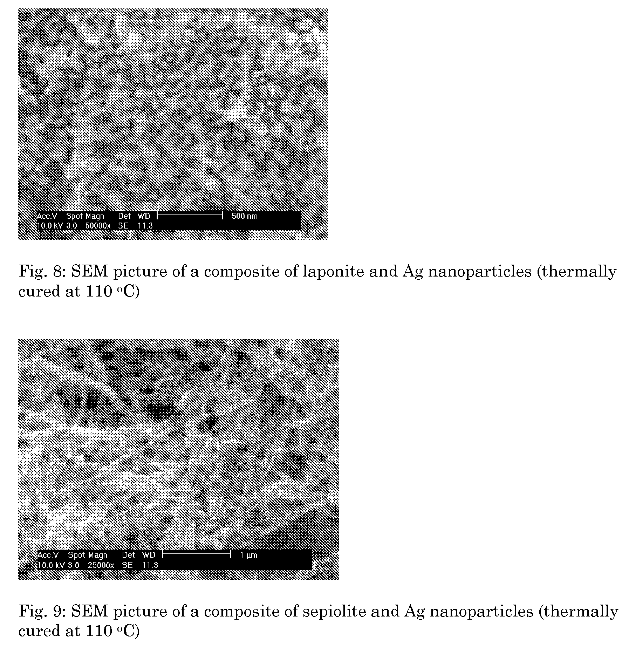

Figure 8 shows a SEM picture of a composite of laponite and Ag nanoparticles, thermally cured at 110 °C.

Figure 9: shows SEM picture of a composite of sepiolite and Ag nanoparticles (thermally cured at 110 °C).

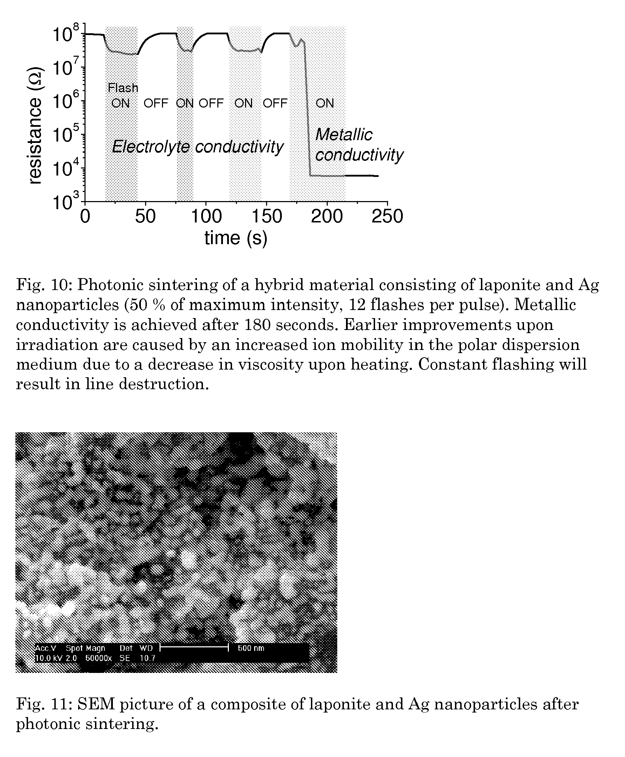

Figure 10 shows how conductivity/resistance is afffected by photonic sintering of a hybrid material consisting of laponite and Ag nanoparticles (50 % of maximum intensity, 12 flashes per pulse). Metallic conductivity is achieved after 180 seconds.

Figure 11 shows a SEM picture of a composite of laponite and Ag nanoparticles after photonic sintering.

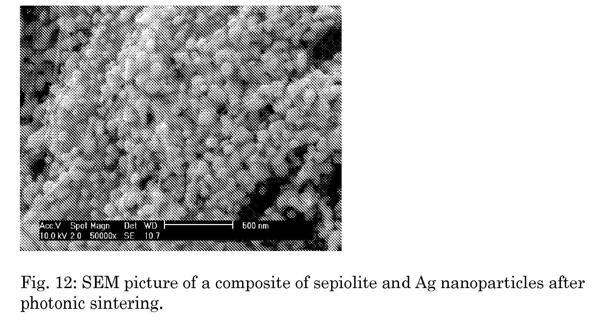

Figure 12 shows a SEM picture of a composite of sepiolite and Ag nanoparticles after photonic sintering.

## Claims

1. Method for preparing a conductive or semi-conductive element, comprising
- providing a dispersion of an anisotropic particulate hybrid material in a continuous phase, which hybrid material comprises (a) anisotropic particles, and (b) a conductive or semi-conductive material or a precursor for a conductive or semi-conductive material;
- applying the dispersion to a surface of a substrate; and
- forming the conductive or semi-conductive element from the dispersion applied to the surface.

2. Method according to claim 1, wherein the anisotropic particles (a) are selected from the group of anisotropic graphite particles (such as graphite sheets), carbon-nanotubes, clay minerals, inorganic layered chalcogenides (MoS₂ or WS₂) and oxides having the form of nanosheets or nanorods, in particular selected from the groups of clays and graphite.

3. Method according to claim 3, wherein the anisotropic particles (a) are exfoliated clay particles.

4. Method according to any of the preceding claims, wherein the anisotropic particles (a) have an (average) aspect ratio of at least 1:5, preferably of 1:10 to 1:10000, in particular of 1:100 to 1:1000 as determined by laser diffraction.

5. Method according to any of the preceding claims, wherein the hybrid material comprises a conductive or semi-conductive material selected from the group aluminium, gallium, silver, gold, copper, nickel, silicon, gallium indium zinc oxide, copper indium gallium selenide, gallium nitride, gallium arsenide, indium phosphide, cadmium indium selenide, cadmium selenide, cadmium sulphide, zinc sulphide and silicon carbide.

6. Method according to any of the preceding claims, wherein the dispersion is applied to the surface using a printing technique, in particular a printing technique selected from inkjet printing, flexo printing, screen printing, gravure printing, valve printing and aerosol jetting.

7. Method according to any of the preceding claims, wherein the dispersion is applied by a roll-to-roll technique.

8. Method according to any of the preceding claims, wherein the forming of the conductive or semi-conductive element comprises a sintering step.

9. Method according to any of the preceding claims, wherein the concentration of the hybrid material in the dispersion is 10 to 90 wt.%, in particular 15 to 80 wt. %, more in particular 20 to 70 wt. %.

10. Method according to any of the preceding claims, wherein the conductive or semi-conductive material or precursor for a conductive or semi-conductive material (b) is a nanoparticulate material and wherein preferably the anisotropic particles (b) have at least one dimension in the range of 1 to 100 nm.

11. A particulate anisotropic hybrid material, which hybrid material comprises (a) anisotropic particles, and (b) a conductive or semi-conductive material or a precursor for a conductive or semi-conductive material, wherein the anisotropic particulate hybrid material is as defined in any of the preceding claims, the ratio anisotropic particles (a): to the conductive or semi-conductive material or a precursor for a conductive or semi-conductive material (b).

12. A dispersion, which dispersion may be a fluid or a paste, comprising a particulate hybrid material according to claim 11.

13. A dispersion according to claim 12, comprising at least one additive selected from the group of viscosity modifiers, surface tension modifiers and dispersing agents.

14. A conductive or semi-conductive element comprising a conductive or semi-conductive hybrid material, the hybrid material comprising (a) anisotropic particles and (b) a conductive or semi-conductive material, wherein said anisotropic particles and said conductive or semi-conductive material is as defined in any of the claims 1-11.

15. Electronic device, in particular an electronic device comprising an organic electronic device, comprising a conductive or semi-conductive element according to claim 14.

16. Method according to any of the claims 1-10, dispersion according to claim 12 or 13, hybrid material according to claim 11, element according to claim 14 or electronic device according to claim 15, wherein the anisotropic particles (a) and the conductive or semi-conductive material or precursor for the conductive or semi-conductive material (b) are present in a wt. to wt. ratio (a):(b) in the range 100: 1 to 1:20000, in particular in the range of 1:1 to 1:5000, more in particular in the range of 1:10 to 1 : 2000.
